# EUROPÄISCHE PATENTANMELDUNG

(11) **EP 2 207 043 A1**
(43) Veröffentlichungstag der Anmeldung: **14.07.2010**
(21) Anmeldenummer: 09000258.5
(22) Anmeldetag: 10.01.2009
(51) Int. Cl.: G01R 21/133

(54) **Eelektronischer Elektrizitätszähler und Verfahren zur Erfassung einer elektrischen Energiemenge mit einem elektronischen Elektrizitätszähler**

(71) Anmelder: EMH Elektrizitätszähler GmbH & Co KG, 19243 Wittenburg (DE)
(72) Erfinder: Schmelzer, Wolfram, 21075 Hamburg (DE)
(74) Vertreter: Graalfs, Edo

(57) **Zusammenfassung**

Elektronischer Elektrizitätszähler mit
• einer Messeinrichtung (10) zur Erfassung von Messwerten für Spannung und Strom,
• einem Rechenwerk (12) zur Berechnung einer Energiemenge auf Grundlage der Messwerte für Spannung und Strom,
• einem Tarifwerk (14), das unterschiedliche Tarife (T1,T2,T3) enthält, die auf die berechnete Energiemenge angewendet werden können, um eine Abrechnungsgröße zu berechnen,
• einer Ausgabeeinrichtung (16), die die Abrechnungsgröße zur Ablesung und/oder automatischen Weiterleitung zur Verfügung stellen kann,
• einer Schaltuhr (20),
• einer Empfangseinrichtung (22) zum Empfang externer Tarifbefehle, und
• einer Tarifsteuereinrichtung (18), die mit dem Tarifwerk, der Schaltuhr und der Empfangseinrichtung verbunden ist und einen Tarif wahlweise nach Maßgabe der Schaltuhr oder nach Maßgabe eines externen Tarifbefehls auswählen kann, wobei ein Tarif nach Maßgabe der Schaltuhr nur dann ausgewählt wird, wenn innerhalb einer vorgegebenen Zeitdauer kein externer Tarifbefehl empfangen worden ist.

## Beschreibung

Die Erfindung betrifft einen elektronischen Elektrizitätszähler und ein Verfahren zur Erfassung einer elektrischen Energiemenge mit einem elektronischen Elektrizitätszähler. Derartige Zähler dienen der Erfassung einer verbrauchten oder in ein Netz eingespeisten Energiemenge. Die erfasste Energiemenge ist die Grundlage für die Abrechnung nach einem vorgegebenen Tarif. Häufig kommen bei der Abrechnung unterschiedliche Tarife zum Einsatz, beispielsweise ein Tag- und ein Nachttarif. Insbesondere bei Großkunden gibt es jedoch auch weitaus kompliziertere Tarifstrukturen, die eine Vielzahl unterschiedlicher Tarife benötigen.

Um unterschiedliche Tarife bei der Abrechnung anwenden zu können, bedarf es einer Tarifsteuerung. Hierzu ist es bei elektronischen Elektrizitätszählern bekannt, unterschiedliche Tarife in einem sogenannten Tarifwerk des Zählers zu hinterlegen und den jeweils anzuwendenden Tarif mit Hilfe eines externen Tarifbefehls auszuwählen. Um einen Zähler mit einer solchen Tarifsteuerung betreiben zu können, ist daher eine Verbindung zum Zähler notwendig, über die der Tarifbefehl erteilt werden kann, beispielsweise eine Telefonleitung.

Andere elektronische Elektrizitätszähler weisen zur Tarifsteuerung eine interne Schaltuhr auf, die abhängig von der aktuellen Uhrzeit einen der hinterlegten Tarife aktiviert. Derartige Zähler können unabhängig von einer Verbindung nach außen betrieben werden, sind allerdings hinsichtlich der Tarifsteuerung weniger flexibel einsetzbar.

Beide skizzierten Zählertypen sind auf die jeweils vorgesehene Art der Tarifsteuerung festgelegt.

Davon ausgehend ist es die Aufgabe der Erfindung, einen elektronischen Elektrizitätszähler und ein Verfahren zur Erfassung einer elektrischen Energiemenge mit einem elektronischen Elektrizitätszähler zur Verfügung zu stellen, der bzw. das universell einsetzbar ist.

Diese Aufgabe wird gelöst durch den elektronischen Elektrizitätszähler mit den Merkmalen des Anspruchs 1 und durch das Verfahren mit den Merkmalen des Anspruchs 3. Vorteilhafte Ausgestaltungen sind in den sich jeweils anschließenden Unteransprüchen angegeben.

Der erfindungsgemäße elektronische Elektrizitätszähler hat
- eine Messeinrichtung zur Erfassung von Messwerten für Spannung und Strom,
- ein Rechenwerk zur Berechnung einer Energiemenge auf Grundlage der Messwerte für Spannung und Strom,
- ein Tarifwerk, das unterschiedliche Tarife enthält, die auf die berechnete Energiemenge angewendet werden können, um eine Abrechnungsgröße zu berechnen,
- eine Ausgabeeinrichtung, die die Abrechnungsgröße zur Ablesung und/oder automatischen Weiterleitung zur Verfügung stellen kann,
- eine Schaltuhr,
- eine Empfangseinrichtung zum Empfang externer Tarifbefehle, und
- eine Tarifsteuereinrichtung, die mit dem Tarifwerk, der Schaltuhr und der Empfangseinrichtung verbunden ist und einen Tarif wahlweise nach Maßgabe der Schaltuhr oder nach Maßgabe eines externen Tarifbefehls auswählen kann, wobei ein Tarif nach Maßgabe der Schaltuhr nur dann ausgewählt wird, wenn innerhalb einer vorgegebenen Zeitdauer kein externer Tarifbefehl empfangen worden ist.

Es versteht sich, dass die genannten Komponenten des Zählers, insbesondere das Rechenwerk, das Tarifwerk und die Schaltuhr, in Form von Software realisiert sein können, die auf einem Mikroprozessor des Zählers läuft.

Ein Tarif ist eine Vorschrift, die einer Energiemenge eine Abrechnungsgröße zuordnet, beispielsweise in Form eines Geldbetrags pro Kilowattstunde, oder in Form einer anderweitig normierten Größe, die zu einem späteren Zeitpunkt in einen Geldbetrag umgerechnet werden kann. Die Tarife sind in einem Tarifwerk enthalten, d.h. insbesondere in geeigneten Speicherbereichen gespeichert, beispielsweise in Form einer Tabelle. Die Anzahl hinterlegter Tarife kann unterschiedlich sein, mindestens sind jedoch zwei unterschiedliche Tarife vorhanden, beispielsweise ein Tag- und ein Nachttarif. Es können jedoch auch zehn oder mehr Tarife hinterlegt sein.

Die Ausgabeeinrichtung stellt die durch Anwendung der Tarife auf die Energiemengen ermittelte Abrechnungsgröße zur Verfügung. Es kann sich beispielsweise um eine einfache Anzeige handeln, die die Abrechnungsgröße anzeigt. Es kann jedoch auch eine Fernablesung beispielsweise über Funk vorgesehen sein, oder eine sonstige Möglichkeit der Übermittlung, die eine weitere Verarbeitung der Abrechnungsgröße erlaubt.

Die Schaltuhr kann abhängig von einer aktuellen Uhrzeit unterschiedliche Zustände annehmen und in diesem Sinne zwischen den unterschiedlichen Zuständen umschalten. Jeder Zustand der Schaltuhr kann einem bestimmten Tarif zugeordnet sein.

Die Empfangseinrichtung zum Empfang externer Tarifbefehle kann in ein Gehäuse des Zählers integriert oder außerhalb des Zählers, beispielsweise in oder an einer Grundplatte angeordnet sein, und eine entsprechende Verbindung zum Zähler aufweisen. Die Empfangseinrichtung kann die externen Tarifbefehle beispielsweise über Funk, über eine gesonderte Kommunikationsleitung oder über ein auf die Stromleitung aufmoduliertes Signal empfangen. Der externe Tarifbefehl kann insbesondere ein einfacher Steuerbefehl sein, der die Anwendung eines bestimmten Tarifs vorschreibt.

Die Auswahl, welcher der in dem Tarifwerk enthaltenen unterschiedlichen Tarife anzuwenden ist, obliegt der Tarifsteuereinrichtung. Die Tarifsteuereinrichtung ist zu diesem Zweck sowohl mit der Schaltuhr als auch mit der Empfangseinrichtung verbunden und kann wahlweise den nach Maßgabe der Schaltuhr oder nach Maßgabe eines externen Tarifbefehls gewünschten Tarif auswählen.

Der erfindungsgemäße Zähler hat den Vorteil, dass er sowohl unabhängig von einer externen Verbindung mit der Schaltuhr, als auch mit externen Steuerbefehlen betrieben werden kann. Er ist daher universell einsetzbar. Die Tarifsteuereinrichtung kann zwischen beiden möglichen Betriebsarten wählen. Insbesondere können beide Betriebsarten auch gleichzeitig aktiv sein, wobei die Tarifsteuereinrichtung zu einem gegebenen Zeitpunkt entscheidet, welche der beiden Betriebsarten über den anzuwendenden Tarif entscheidet.

Grundsätzlich ist es denkbar, die von der Tarifsteuerung zu treffende Wahl beispielsweise bei der Inbetriebnahme oder Installation des Zählers durch eine entsprechende Beschaltung fest vorzugeben. Möglich ist eine feste Vorgabe auch zu einem späteren Zeitpunkt, beispielsweise durch einen Servicetechniker. Bei der Erfindung ist die Tarifsteuereinrichtung hingegen so ausgebildet, dass ein Tarif nach Maßgabe der Schaltuhr nur dann ausgewählt wird, wenn innerhalb einer vorgegebenen Zeitdauer kein externer Tarifbefehl empfangen worden ist. Es erfolgt demnach keine feste Vorgabe, welche Betriebsart von der Tarifsteuerung auszuwählen ist. Stattdessen prüft die Tarifsteuereinrichtung selbsttätig in einem vorgegebenen Zeittakt, ob ein externer Tarifbefehl empfangen worden ist. Wenn dies der Fall ist, wird der anzuwendende Tarif von der Tarifsteuereinrichtung nach Maßgabe des externen Steuerbefehls ausgewählt. Falls kein externer Steuerbefehl empfangen worden ist, wird der Tarif von der Tarifsteuereinrichtung automatisch nach Maßgabe der Schaltuhr ausgewählt. Demnach hat der externe Steuerbefehl Vorrang. Trotz dieses Vorrangs ist sichergestellt, dass eine Tarifauswahl nach Maßgabe des externen Steuerbefehls nur dann erfolgt, wenn tatsächlich ein aktueller externer Steuerbefehlt vorliegt. Hierfür ist eine regelmäßige Bestätigung bzw. Wiederholung des externen Steuerbefehls erforderlich. Wird kein externer Steuerbefehl empfangen, ist dennoch eine sinnvolle Abrechnung nach Maßgabe der internen Schaltuhr möglich. Ein weiterer Vorteil ist, dass jederzeit zwischen den beiden Betriebsarten umgeschaltet werden kann, ohne dass eine Konfigurationsmaßnahme am Zähler erforderlich ist. Dadurch ist der Zähler besonders flexibel einsetzbar.

In einer weiteren Ausgestaltung ist die Empfangseinrichtung so ausgebildet, dass sie einen neuen Tarif zur Hinterlegung in dem Tarifwerk und/oder Anwendung auf eine berechnete Energiemenge empfangen kann. Anders als bei dem Empfang eines externen Tarifbefehls, der lediglich eine Auswahl aus den bereits in dem Tarifwerk hinterlegten Tarifen ermöglicht, kann bei dieser Ausgestaltung eine weitergehende Tarifinformation übertragen werden. Diese kann entweder in einem freien Speicherplatz des Tarifwerks hinterlegt werden, oder einen bereits dort hinterlegten Tarif ersetzen. Alternativ ist auch daran gedacht, den neuen Tarif unmittelbar auf eine berechnete Energiemenge anzuwenden. Durch die Möglichkeit, neue Tarife zu übermitteln, kann der Zähler noch flexibler eingesetzt werden.

Die oben genannte Aufgabe wird ebenfalls gelöst durch das Verfahren mit den Merkmalen des Anspruchs 3.

Das Verfahren dient zur Erfassung einer elektrischen Energiemenge mit einem elektronischen Elektrizitätszähler, das die folgenden Schritte aufweist:
- Erfassen von Messwerten für Spannung und Strom,
- Berechnen einer Energiemenge auf Grundlage der Messwerte für Spannung und Strom,
- Prüfen, ob ein externer Tarifbefehl vorliegt,
- Auswahl eines Tarifs nach Maßgabe einer Schaltuhr oder nach Maßgabe eines externen Tarifbefehls,
- Anwenden des ausgewählten Tarifs auf die berechnete Energiemenge.

Auch das Verfahren bietet die oben erläuterten Vorteile des erfindungsgemäßen Elektrizitätszählers. Insbesondere ist die Auswahl eines Tarifs sowohl nach Maßgabe einer Schaltuhr als auch nach Maßgabe eines externen Tarifbefehls vorgesehen.

Hinsichtlich weiterer Besonderheiten des Verfahrens und der Merkmale der Unteransprüche wird auf die obige Erläuterung des Zählers verwiesen.

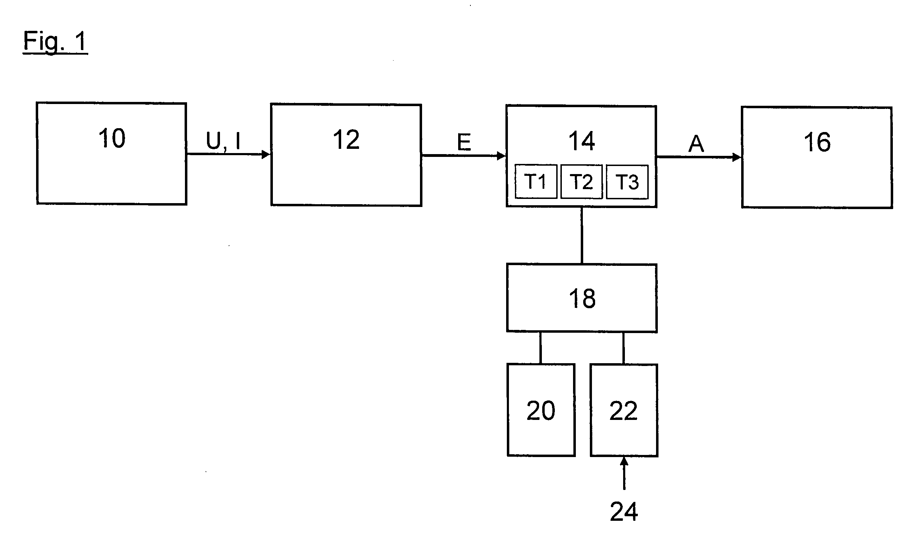

Die Erfindung wird nachfolgend anhand eines in einer Figur dargestellten Ausführungsbeispiels näher erläutert. Die einzige Figur zeigt schematisch und vereinfacht den Aufbau eines erfindungsgemäßen Zählers.

Der Zähler hat eine Messeinrichtung 10 zur Erfassung von Messwerten für Spannung U und Strom I. Die erfassten Messwerte werden - wie durch den entsprechend beschrifteten Pfeil angedeutet - an ein Rechenwerk 12 weitergeleitet. Das Rechenwerk 12 berechnet auf Grundlage der Messwerte für Spannung U und Strom I eine Energiemenge E. Selbstverständlich wird bei der Berechnung der Energiemenge E in an sich bekannter Weise die verstrichene Zeit berücksichtigt.

Die berechnete Energiemenge E wird an das Tarifwerk 14 weitergeleitet. Das Tarifwerk 14 enthält, beispielsweise in entsprechenden Speicherbereichen, unterschiedliche Tarife T1, T2, T3.

Eine interne Schaltuhr 20 des Zählers ist mit einer Tarifsteuereinrichtung 18 verbunden. Ebenfalls mit der Tarifsteuereinrichtung 18 verbunden ist die Empfangseinrichtung 22, die einen externen Tarifbefehl 24 empfangen kann. Die Tarifsteuereinrichtung 18 wählt einen der im Tarifwerk 14 hinterlegten Tarife T1, T2, T3 aus, wobei bei dieser Auswahl wahlweise der Zustand der Schaltuhr 20 oder ein von der Empfangseinrichtung 22 empfangener externer Tarifbefehl 24 zugrunde gelegt wird. Im skizzierten Ausführungsbeispiel hat der externe Steuerbefehl 24 Vorrang. Wird innerhalb einer vorgegebenen Zeitdauer, beispielsweise innerhalb einer Minute, ein externer Tarifbefehl 24 empfangen, wird der dem Tarifbefehl 24 entsprechende Tarif von der Tarifsteuereinrichtung 18 ausgewählt. Wird innerhalb der genannten Zeitdauer hingegen kein externer Steuerbefehl 24 empfangen, wird der Tarif von der Tarifsteuereinrichtung 18 nach Maßgabe der Schaltuhr 20 ausgewählt. Der jeweils ausgewählte Tarif wird auf die berechnete Energiemenge E angewendet, was eine Abrechnungsgröße A ergibt. Diese wird mit Hilfe der Ausgabeeinrichtung 16 angezeigt oder auf sonstige Weise für die weitere Verarbeitung verfügbar gemacht.

## Patentansprüche

1. Elektronischer Elektrizitätszähler mit
• einer Messeinrichtung (10) zur Erfassung von Messwerten für Spannung (U) und Strom (I),
• einem Rechenwerk (12) zur Berechnung einer Energiemenge (E) auf Grundlage der Messwerte für Spannung (U) und Strom (I),
• einem Tarifwerk (14), das unterschiedliche Tarife enthält, die auf die berechnete Energiemenge (E) angewendet werden können, um eine Abrechnungsgröße (A) zu berechnen,
• einer Ausgabeeinrichtung (16), die die Abrechnungsgröße (A) zur Ablesung und/oder automatischen Weiterleitung zur Verfügung stellen kann,
• einer Schaltuhr (20),
• einer Empfangseinrichtung (22) zum Empfang externer Tarifbefehle (24), und
• einer Tarifsteuereinrichtung (18), die mit dem Tarifwerk (14), der Schaltuhr (20) und der Empfangseinrichtung (22) verbunden ist und einen Tarif wahlweise nach Maßgabe der Schaltuhr (20) oder nach Maßgabe eines externen Tarifbefehls (24) auswählen kann, wobei die Tarifsteuereinrichtung (18) so ausgebildet ist, dass ein Tarif nach Maßgabe der Schaltuhr nur dann auswählt wird, wenn innerhalb einer vorgegebenen Zeitdauer kein externer Tarifbefehl empfangen worden ist.

2. Elektrizitätszähler nach Anspruch 1, **dadurch gekennzeichnet, dass** die Empfangseinrichtung so ausgebildet ist, dass sie einen neuen Tarif zur Hinterlegung in dem Tarifwerk (14) und/oder Anwendung auf eine berechnete Energiemenge (E) empfangen kann.

3. Verfahren zur Erfassung einer elektrischen Energiemenge (E) mit einem elektronischen Elektrizitätszähler, das die folgenden Schritte aufweist:
• Erfassen von Messwerten für Spannung (U) und Strom (I),
• Berechnen einer Energiemenge (E) auf Grundlage der Messwerte für Spannung (U) und Strom (I),
• Prüfen, ob eine externer Tarifbefehl (24) vorliegt,
• Auswahl eines Tarifs nach Maßgabe einer Schaltuhr oder nach Maßgabe eines externen Tarifbefehls (24),
• Anwenden des ausgewählten Tarifs auf die berechnete Energiemenge (E).

4. Verfahren nach Anspruch 3, **dadurch gekennzeichnet, dass** das Prüfen, ob ein externer Tarifbefehl vorliegt, eine vorgegebene Zeitdauer umfasst und ein Tarif nach Maßgabe der Schaltuhr nur dann ausgewählt wird, wenn innerhalb dieser Zeitdauer kein externer Tarifbefehl empfangen worden ist.

5. Verfahren nach Anspruch 3 oder 4, **dadurch gekennzeichnet, dass** ein neuer Tarif empfangen und in einem Tarifwerk hinterlegt und/oder auf eine berechnete Energiemenge (E) angewendet wird.
